(19)

Europäisches
Patentamt
European
Patent Office
Office européen
des brevets

(11) **EP 1 801 067 A2**

(12) **EUROPEAN PATENT APPLICATION**

(43) Date of publication:
**27.06.2007  Bulletin 2007/26**

(51) Int Cl.:
**B81C 1/00** (2006.01)

(21) Application number: **06026404.1**

(22) Date of filing: **20.12.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **21.12.2005  US 754072**

(71) Applicants:
• **Interuniversitair Microelektronica Centrum 3001 Leuven (BE)**
• **American University Cairo 11511 Cairo (EG)**

(72) Inventors:
• **Sedky, Sherif Dokki Gize (EG)**
• **Witvrouw, An 3020 Herent (BE)**

(74) Representative: **Bird, William Edward et al Bird Goen & Co., Klein Dalenstraat 42A 3020 Winksele (BE)**

(54) **Method for forming silicon germanium layers at low temperatures for controlling stress gradient**

(57)   The present invention provides a method for controlling the average stress and the strain gradient in structural silicon germanium layers as used in micromachined devices. The method comprises depositing a single silicon germanium layer on a substrate and annealing a predetermined part of the deposited silicon germanium layer, whereby the process parameters of the depositing step and/or the annealing step are selected such that a predetermined average stress and a predetermined strain gradient are obtained in the predetermined part of the silicon germanium layer. Preferably a plasma assisted deposition technique is used for depositing the silicon germanium layer, and a pulsed excimer laser is used for local annealing, with a limited thermal penetration depth. The present invention provides a method for forming structural silicon germanium layers for surface micromachined structures at temperatures substantially below 400°C, which offers for example the possibility of post-processing micromachined structures on top of a substrate comprising electronic circuitry such as CMOS circuitry, without affecting the functionality and reliability of the electronic circuitry. More in particular, the present invention provides a method for forming structural silicon germanium layers at temperatures not exceeding 210°C, which allows the integration of silicon germanium based micromachined structures on substrates such as polymer films.

Figure 4

EP 1 801 067 A2

**Description**

**Field of the invention**

The present invention is related to methods of manufacturing silicon germanium layers and in particular to the formation of structural silicon germanium layers having a low average stress and a low internal strain gradient suitable for forming micromachined devices. More in particular the invention is related to the formation of such silicon germanium layers at low temperatures.

**Background**

The demand for implementing MEMS (Micro Electro Mechanical Systems) in various systems is increasing tremendously. To increase integration density and to improve performance and system reliability, it is beneficial to integrate MEMS monolithically with the driving and control electronic circuitry. There are different approaches for MEMS monolithic integration. For high-density integration it is preferred to post-process MEMS on top of prefabricated electronics, as this allows using standard CMOS wafers from a foundry and at the same time improving the fill factor significantly. Post-processing restricts the MEMS thermal budget, as it should not introduce any damage or degradation to the performance of the prefabricated driving electronics. To avoid degradation in the functionality and reliability of advanced Cu/low k electronics, the post-processing temperature is preferably below 400°C. Additionally, processing on top of other (low cost) substrates such as plastics requires silicon germanium deposition at temperatures below 400°C.
For many micromachined devices, such as transducers and other freestanding structures, the mechanical properties of the applied thin films can be critical to their success. For example, stress or strain gradients can cause freestanding thin film structures to warp to the point that these structures become useless. Such thin film layers ideally have a low stress and a zero strain gradient in a direction perpendicular to the layer surface. Strain gradient can be defined as the stress gradient divided by the Young's modulus of the material. If the stress is compressive, structures can buckle. If the tensile stress is too high, structures can break. If the strain gradient is different from zero, microstructures can deform, for example, cantilevers can bow. Therefore processes for forming MEMS structural layers should be optimized to control the internal stress and the strain gradient, at the same time realizing the desired electrical properties (e.g. a low electrical resistivity).
Polycrystalline silicon germanium is an attractive material for MEMS post-processing, allowing realizing good electrical, mechanical and thermal properties at temperatures that are lower than the temperatures required for polycrystalline silicon processing.
In US 2003/0124761, the development of low-stress polycrystalline silicon germanium layers under different deposition conditions is described. Some deposition conditions examined, for example, include: deposition temperature; concentration of semiconductors (e.g. the concentration of silicon and germanium in a $Si_xGe_{1-x}$ layer, with x being the concentration parameter); concentration of dopants (e.g. the concentration of boron or phosphorous); amount of pressure; and use of plasma. These layers can be in-situ doped. Depositions are performed with (PECVD) or without (CVD) plasma power at pressures between 300 mTorr and 760 Torr and at temperatures between 400°C and 600°C.
Fast deposition methods such as PACVD (Plasma Assisted Chemical Vapor Deposition) or PECVD (Plasma Enhanced Chemical Vapor Deposition) typically yield amorphous layers with high stress and high resistivity at temperatures compatible with CMOS, at low germanium concentrations. Polycrystalline layers deposited with PECVD with low stress and low resistivity are described in WO01/74708, but these layers are deposited only at high temperatures (above 550°C).
Slow deposition methods such as CVD can yield crystalline layers with a low resisitivity at 450°C. In WO01/74708 it is indicated that the CVD deposition of in situ boron doped polycrystalline silicon germanium at lower temperature (about 400°C) is feasible if the germanium concentration is sufficiently high (above 70%) and if the boron concentration is sufficiently high (above $10^{19}/cm^3$). In addition, an additional anneal at 450°C is needed to optimize the mechanical properties of this layer.
In US 2005/0037598 a method of producing polycrystalline silicon germanium layers suitable for micromachining is described, the method including depositing onto a substrate a first layer including polycrystalline silicon germanium, wherein the deposition includes non-plasma chemical vapor deposition, and depositing onto the first layer a second layer including polycrystalline silicon germanium, wherein the deposition includes plasma enhanced chemical vapor deposition. In a preferred embodiment a combination of CVD and PECVD or PACVD processes is used to obtain polycrystalline films at a low temperature compatible with CMOS (450°C or lower). It is demonstrated that for deposition at 450°C a low stress, low resistivity layer is obtained at a reasonable deposition rate.
Depending on the germanium concentration and the deposition pressure, the transition temperature from amorphous to polycrystalline silicon germanium layers can be reduced to 400°C. At lower deposition temperatures substantially amorphous layers with high electrical resistance are obtained and subsequent crystallization by annealing is required to make these layers suitable for MEMS structural layers, whereby at the same time good mechanical properties should be realized. This annealing step should be performed with a low thermal budget compatible with the underlying substrate and the underlying structures.

Over the last two decades excimer laser annealing has been considered as an efficient low thermal budget technique for locally modifying the physical properties of thin films, without introducing any damage or modifications to the underlying layers. The early motivation for using pulsed laser annealing was to control the grain size and crystallinity of amorphous silicon, which was attractive for the fabrication of thin film transistors (TFTs) having a high field effect mobility on glass substrates. Also, it was commonly used to tune the electrical properties of implanted semiconductors especially for devices that require shallow doped regions. Furthermore, it has been demonstrated that pulsed laser annealing can noticeably improve the efficiency of solar cells as it enhances the minority carrier diffusion length. The fact that pulsed laser annealing reduces the defect density due to the melting and re-crystallization mechanism widened the application of this technique to improve the electrical properties of metal induced crystallized amorphous silicon thin films. Many studies have been performed to understand the effect of laser annealing on the average grain size and stress of silicon films deposited by low-pressure chemical vapor deposition (LPCVD) or radio-frequency (RF) sputtering. Furthermore the effects of pulsed laser annealing on the electrical and structural properties of silicon and silicon germanium are widely investigated.

The application of pulsed laser annealing for local crystallization, at the same time controlling the stress and strain gradient in structural layers of surface micromachined MEMS devices that are processed on top of standard pre-fabricated driving electronics is much more challenging. MEMS processing implies the use of rather thick layers and requires the optimization of the mechanical and electrical properties of these layers. Accordingly the laser annealing conditions are completely different from those conventionally implemented.

In "Pulsed-laser Annealing, a Low-Thermal Budget Technique for Eliminating Stress Gradient in Poly-SiGe MEMS structures", Journal of Microelectromechanical systems, Vol. 13, no 4, august 2004, S. Sedky et al. proposed a method for controlling the stress and strain gradient in silicon germanium bi-layers deposited between 400°C and 425°C using LPCVD (Low Pressure Chemical Vapor Deposition). It was shown that pulsed excimer laser annealing can completely eliminate the strain gradient when using a dual layer of silicon germanium. Moreover, the electrical conductivity can be as low as 0.5 mOhm cm. The proposed method comprises the steps of forming a first polycrystalline silicon germanium layer on a substrate, forming large grains at the surface of this first polycrystalline silicon germanium layer by means of pulsed excimer laser annealing, and forming a second polycrystalline silicon germanium layer on top of this first layer. Due to the presence of the large grains in the first polycrystalline silicon germanium layer, the crystals of the second polycrystalline silicon germanium layer will preferably grow in a direction perpendicular to the interface between the two silicon germanium layers. These columnar crystals assist in reducing the strain gradient of the bi-layer. However, because of the low LPCVD deposition rate (< 5 nm/min at 400°C), it is not practical to deposit the silicon germanium layers at temperatures below 400°C as required for post- processing. Depending on the required layer thickness, the underlying driving electronics might be exposed to the deposition temperature for a long period (up to several hours), which may have a negative impact on the electronics characteristics and reliability. Moreover the method requires the formation of two layers with an intermediate laser anneal step.

## Aim of the invention

The present invention has as an objective the development of a method for controlling the average stress and the strain gradient in structural silicon germanium layers as used in micromachined devices. Strain gradient can be defined as the stress gradient divided by the Young's modulus of the material.

## Summary of the Invention

Embodiments of the present invention can provide a method for forming structural silicon germanium layers for surface micromachined MEMS devices at temperatures substantially below 400°C, independent of the driving electronics fabrication process and the substrate type used. A method according to the present invention may comprise selecting the physical properties of the MEMS structural layers locally, with a thermal treatment that has limited thermal penetration depth and accordingly does not affect the underlying layers. A method according to the present invention allows integration of the micromachined devices with the driving electronics, thereby providing superior properties of the silicon germanium structural layers, such as low average stress and strain gradient, electrical and thermal conductivity, surface roughness and internal dissipation that are suitable for a broad range of MEMS applications.

More in particular, some embodiments of the invention can allow processing of high quality structural silicon germanium layers at temperatures below 250 °C. By using a suitable deposition technique such as Chemical Vapor Deposition, especially PECVD or other plasma assisted deposition techniques for the deposition of the silicon germanium layers, the growth rate is enhanced, which gives the possibility to reduce the deposition temperature. Processing of high quality silicon germanium layers at temperatures not exceeding 210 °C allows the integration of silicon germanium based MEMS on other substrates (besides CMOS) such as polymer films.

A method according to the present invention comprises depositing a single silicon germanium layer on a substrate for use as a structural layer in micromachined structures and annealing a predetermined part of the deposited silicon germanium layer, whereby the process parameters of the depositing step and/or the annealing step are selected such that a predetermined average stress and a predetermined strain gradient are obtained in the predetermined part of the silicon germanium layer, making the predetermined part of the silicon germanium layer suitable for use as a structural layer in micromachined structures or micromachined devices.. Advantages of the method according to the present invention are for example that only a single layer of silicon germanium is needed, and that the average stress and the strain gradient may be controlled locally, in a predetermined part of the silicon germanium layer, without thermally affecting the underlying layers. This offers for example the possibility of post-processing micromachined structures or micromachined devices on top of a substrate comprising electronic circuitry such as CMOS circuitry, without affecting the functionality and reliability of the electronic circuitry.

Different process parameters for the depositing step and for the annealing step were analyzed. Preferably a PECVD (Plasma Enhanced Chemical Vapor Deposition) process is used for the deposition of the silicon germanium layer. However, other plasma assisted deposition techniques may be used, such as for example High Density Plasma Chemical Vapor Deposition or plasma sputtering. The process parameters studied for the PECVD deposition process include: deposition temperature; deposition pressure; deposition power; thickness of the silicon germanium layer; and the germanium concentration in the silicon germanium layer. For the local annealing step the use of a pulsed laser such as a pulsed excimer laser is preferred, as the wavelength can be absorbed by $Si_xGe_{1-x}$ and the pulse duration is short (24 ns), which provides local heating only. Wavelengths of excimer lasers are typically in the UV region, between 126 nm and 351 nm but the present invention is not necessarily limited to this range.. The process parameters that may be set or adjusted for the laser annealing step in accordance with embodiments of the present invention include: the laser pulse fluence; the number of laser pulses; and the pulse repetition rate.

The deposition of the silicon germanium layer may be performed at a temperature below 400 °C, at a temperature below 370 °C, at a temperature below 350 °C, at a temperature below 300 °C, at a temperature below 250 °C, or at a temperature below 230 °C. Alternatively the deposition of the silicon germanium layer may be performed at a temperature of 210°C or at a temperature below 210°C. The deposition pressure may be between 0,5 Torr and 2 Torr.

The thickness of the silicon germanium layer may be between 0 nm and 2000 nm, or between 500 nm and 1500 nm. The germanium concentration in the silicon germanium layer may be lower than 90%, lower than 70%, lower than 50%, or lower than 30%. Alternatively the germanium concentration in the silicon germanium layer may change gradually over the layer thickness, between 11% Ge and 30% Ge or between 0% Ge and 50% Ge.

The deposition step may result in an amorphous silicon germanium layer.

The deposition step may result in a silicon germanium layer with a compressive stress, whereby the compressive stress is reduced by the annealing step. The deposition step may result in a silicon germanium layer with a compressive stress between 50 MPa and 150 MPa, and the compressive stress may be converted to a low tensile stress (< 100MPa tensile) by the annealing step.

The laser annealing process may be performed with a laser pulse fluence between 20 mJ/cm$^2$ and 600 mJ/cm$^2$, or between 60 mJ/cm$^2$ and 600 mJ/cm$^2$, or between 70 mJ/cm$^2$ and 700 mJ/cm$^2$. The number of laser pulses may be between 1 and 1000, or between 1 and 500. The pulse repetition rate may be between 0 Hz and 50 Hz.

The internal strain gradient of the predetermined part of the silicon germanium layer after performing the annealing step may be between -0.8 $10^{-3}/\mu$m and +0.8 $10^{-3}/\mu$m or between -0.8 $10^{-4}/\mu$m and +0.8 $10^{-4}/\mu$m or between -0.8 $10^{-5}/\mu$m and +0.8 $10^{-5}/\mu$m. The average stress of the predetermined part of the silicon germanium layer after performing the annealing step may be between 50 MPa compressive and 100 MPa tensile.

The process parameters of the annealing step are selected such that the thermal penetration depth is limited to the silicon germanium layer and such that the underlying layers are not affected by the annealing step.

The predetermined part should be understood as part of the silicon germanium layer that is bordered in 3 dimensions. 2 dimensions are located in the plane of the layer and the third dimension is the depth. In a particular embodiment, the predetermined part is the entire deposited silicon germanium layer (meaning the layer covering the entire substrate and including the entire thickness). In another embodiment, the predetermined part of the layer is the top part of the silicon germanium layer. In another embodiment, the predetermined part of the silicon germanium layer should be understood as at least a part of the layer. The predetermined part can be the part of the silicon germanium layer where the cantilever, beam, or suspended structure will be formed. The predetermined part may include the entire thickness of the layer or may only include a top part of the layer.

The substrate may comprise semiconductor material (e.g. doped silicon, gallium arsenide (GaAs), gallium arsenide phosphide (GaAsP), indium phosphide (InP), germanium (Ge), silicon germanium (SiGe)), glass or a polymeric material. In particular the underlying material may comprise at least one semiconductor device made by CMOS processing. The substrate may comprise for example an insulating layer such as a $SiO_2$ or an $Si_3N_4$ layer in addition to a semiconductor substrate portion. Thus, the term substrate also includes substrates like silicon-on-glass, silicon-on sapphire substrates.

In an embodiment, the substrate comprises a sacrificial layer and the silicon germanium layer is deposited on the sacrificial layer. In a further step, the sacrificial layer is removed and a partially freestanding structure is formed that is suitable for MEMS applications.

An advantage of the method provided is that the silicon germanium layer may be deposited at CMOS compatible temperatures, e.g. onto a semiconductor device layer which has been manufactured using CMOS processing. Another advantage is that it allows the formation of a silicon germanium layer with a low average stress and a low strain gradient onto substrates made of polymeric material or glass.

**Brief description of the drawings:**

Figure 1 is a schematic view of a structural layer, indicating the width (w) of the layer and the distance (x) from the neutral plane.

Figure 2 shows a schematic diagram of the beam guiding system of the excimer laser annealing setup.

Figure 3 shows a schematic cross section of the samples used to study the effect of pulsed laser annealing.

Figure 4 is a graph showing the dependence of grain size on pulse fluence. Diamonds represent blocky grains, squares represent fine grains. Solid line fits according to equation (1), dashed line fits according to equation (2).

Figure 5 is a graph showing the dependence of the crystallization depth on pulse fluence. Diamonds represent blocky grains, squares represent fine grains. Solid line fits according to equation (3), dashed line fits according to equation (4).

Figure 6 is a graph showing XRD patterns of the bottom Al layer and the top PECVD $Si_{33}Ge_{67}$ layer deposited at 370°C: (a) as grown, (b) after a single laser pulse at 420 mJ/cm$^2$ and (c) after a single laser pulse at 760 mJ/cm$^2$.

Figure 7 is a graph showing XRD patterns demonstrating the effect of pulse rate at a fixed fluence of 300 mJ/cm$^2$ on the bottom Al layer: (a) single pulse, (b) 100 pulses at 10 Hz and (c) 100 pulses at 50 Hz.

Figure 8 is a graph showing XRD patterns of 0.4 $\mu$m thick PECVD $Si_{25}Ge_{75}$ deposited at 370°C and exposed to: (a) 500 pulses at 50 Hz and 160 mJ/cm$^2$ and (b) 100 pulses at 50 Hz and 300 mJ/cm$^2$.

Figure 9 is a graph showing the effect of Ge content and layer thickness on the stress gradient of $Si_{1-x}Ge_x$ layers deposited at 210°C and 2 Torr: stars (91) are for 0.8 $\mu$m thick $Si_{89}Ge_{11}$ layers, circles (94) for 0.6 $\mu$m thick $Si_{1-x}Ge_x$ multi-layers (Si/$Si_{89}Ge_{11}$/$Si_{79}Ge_{21}$/$Si_{72}Ge_{28}$), diamonds (92) are for 1.5 $\mu$m thick $Si_{89}Ge_{11}$, and squares (93) are for 0.2 $\mu$m thick $Si_{1-x}Ge_x$ multi-layers (Si/$Si_{89}Ge_{11}$/ $Si_{79}Ge_{21}$/$Si_{72}Ge_{28}$).

Figure 10 is a graph showing the effect of Ge content on the average stress of $Si_{1-x}Ge_x$ layers deposited at 210°C and 2 Torr.

Figure 11 is a graph showing the effect of the deposition pressure on the average stress in $Si_{72}Ge_{28}$ layers deposited at 210°C.

Figure 12 is a graph showing the effect of the deposition pressure on strain gradient in $Si_{71}Ge_{29}$ layers deposited at 210°C: circles (122) are for 0.9 $\mu$m thick films deposited at 1 Torr; diamonds (121) are for 1 $\mu$m thick films deposited at 2 Torr.

Figure 13 shows the out-of-plane deflection of surface micromachined cantilevers realized by 0.3 $\mu$m thick $Si_{1-x}Ge_x$ multilayers deposited at 210°C: (a) as-grown, (b) after being exposed to 1000 pulses at 56 mJ/cm$^2$.

Figure 14 shows the effect of pulsed laser annealing on out-of-plane deflection of 1 mm long surface micromachined cantilevers realized by $Si_{1-x}Ge_x$ deposited at 210°C and 2 Torr and having different Ge contents and different thickness. Figure 14.a shows the effect for a 1.2 $\mu$m thick $Si_{72}Ge_{28}$ film: (141) as grown; (142) after 500 pulses at 10 Hz and 56 mJ/cm$^2$; (143) after 1000 pulses at 5 Hz and 56 mJ/cm$^2$.

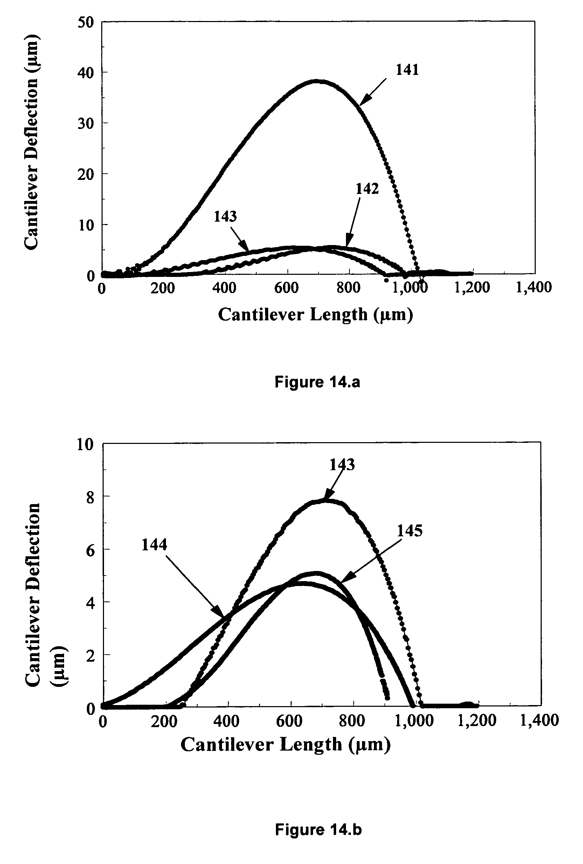

Figure 14.b shows the effect for a 1.5 $\mu$m thick $Si_{89}Ge_{11}$ film: (144) as grown; (145) after 500 pulses at 10 Hz and 56 mJ/cm$^2$; (146) after 1500 pulses at 50 Hz and 56 mJ/cm$^2$.

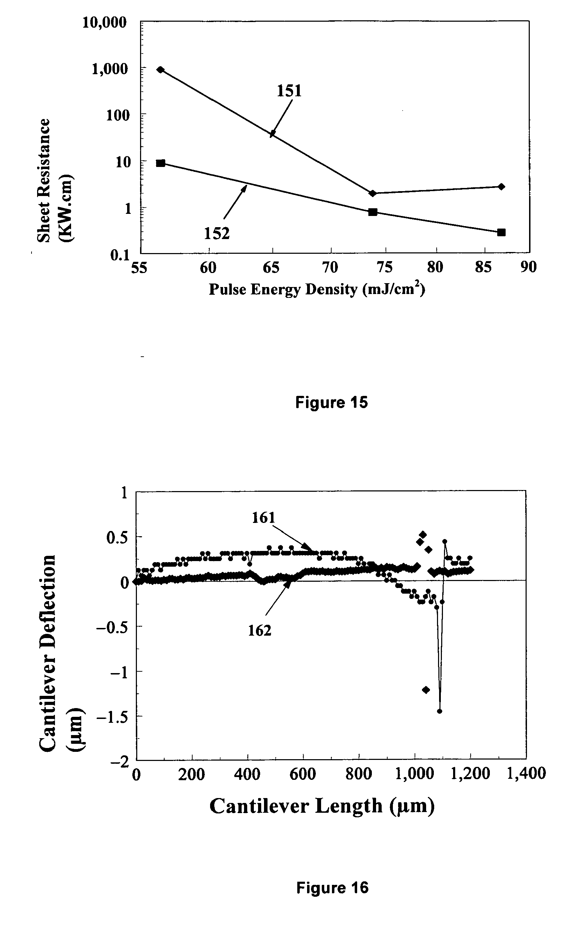

Figure 15 shows the effect of pulse energy density on sheet resistance of $Si_{1-x}Ge_x$ films deposited at 210°C: squares (152) are for 0.75 $\mu$m thick $Si_{31}Ge_{69}$ film exposed to 1000 pulses at 50 Hz, diamonds (151) are for 1 $\mu$m thick $Si_{72}Ge_{28}$ film exposed to 2000 pulses at 50 Hz.

Figure 16 shows the effect of excimer laser annealing on the stress gradient of 0.62 $\mu$m thick $Si_{86}Ge_{14}$ layers deposited at 300°C. Circles (161): as-grown layers, diamonds (162): after 500 laser pulses at 70 mJ/cm$^2$ and 50 Hz.

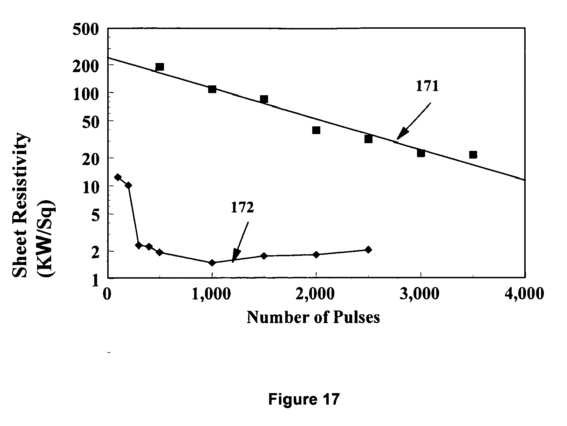

Figure 17 shows the effect of the number of laser pulses on the sheet resistance of 1.8 $\mu$m thick $Si_{72}Ge_{28}$ (171) and 0.7 $\mu$m thick film $Si_{31}Ge_{69}$ (172) layers. Both films have been deposited at 210°C and 0.75 Torr. Pulse fluence and rate are fixed at 56 mJ/cm$^2$ and 50 Hz, respectively. The straight line is an exponential fit for the data.

**Detailed description**

In relation to the appended drawings, the present invention is described in detail below. It is apparent, however, that a person skilled in the art can imagine several other equivalent embodiments or other ways of executing the present invention, the spirit and scope of the present invention being limited only by the terms of the appended claims.

A silicon germanium layer is to be deposited on top of a substrate, e.g. a substrate comprising a semiconductor material, glass or a polymeric material, at a temperature compatible with the underlying material. In particular, the underlying material may comprise at least one semiconductor device, e.g. made by CMOS processing. The term "substrate" used in the description may include any underlying material or materials that may be used, or contain, or upon which a device such as a MEMS device, a mechanical, electronic, electrical, pneumatic, fluidic or semiconductor component or similar, a circuit or an epitaxial layer can be formed. In various embodiments the substrate may include a semiconductor substrate such as, for example, a doped silicon substrate, a gallium arsenide (GaAs) substrate, a gallium arsenide phosphide (GaAsP) substrate, an indium phosphide (InP) substrate, a germanium (Ge) substrate or a silicon germanium (SiGe) substrate. The substrate may include, for example, an insulating layer such as a silicon oxide layer or a silicon nitride layer in addition to a semiconductor substrate portion. Thus the term "substrate" also encompasses substrates such as silicon-on-glass and silicon-on-sapphire substrates. The term "substrate" is thus used to define generally the elements for layers that underlie a layer or portions of interest. The substrate may be any other base on which a layer is formed, for example a glass substrate or a glass or metal layer. In the following, processing will primarily be described with reference to processing silicon substrates, but the skilled person will appreciate that the preferred embodiments can be implemented based on materials such as other semiconductor material systems, glass or polymeric materials and that the skilled person can select suitable materials as equivalents.

Control of stress and strain gradient in thin films is very important for free-standing micromachined structures. Such microstructures or floating microstructure elements are not mechanically supported by other elements or by underlying layers or by the substrate. These structures are only anchored to a substrate, e.g. only connected to the substrate at their perimeter or at some ends. The free-standing micromachined structures are, for example, formed as follows. First a sacrificial layer is deposited onto a substrate. This sacrificial layer may be composed of silicon germanium or silicon oxide or other materials. The active or structural layer is then deposited onto the sacrificial layer and patterned. This active or structural layer, in a preferred embodiment, is composed of silicon germanium, but may alternatively be entirely composed of silicon, entirely composed of germanium or composed of other semiconductors. The sacrificial layer is then at least partially removed, and in a preferred embodiment, entirely removed. Stresses and strain gradients in the active or structural layer then may contribute to warping or bending when the support of the sacrificial layer is removed. Thus, stress and strain gradient in the active or structural layer should be minimized.

Such microstructure devices or elements comprise layers that have ideally a low tensile stress and a zero strain gradient. Preferably, the stress is in the range of -100 MPa to +100 MPa or more preferably in the range of -50 MPa to +10 MPa. The plus-sign (+) denotes a tensile stress whereas the minus-sign (-) indicates a compressive stress in a layer. If the stress is compressive, structures can buckle. If the stress is highly tensile, structures can break. The average internal stress is defined as the integral of the stress over the layer thickness divided by the layer thickness.

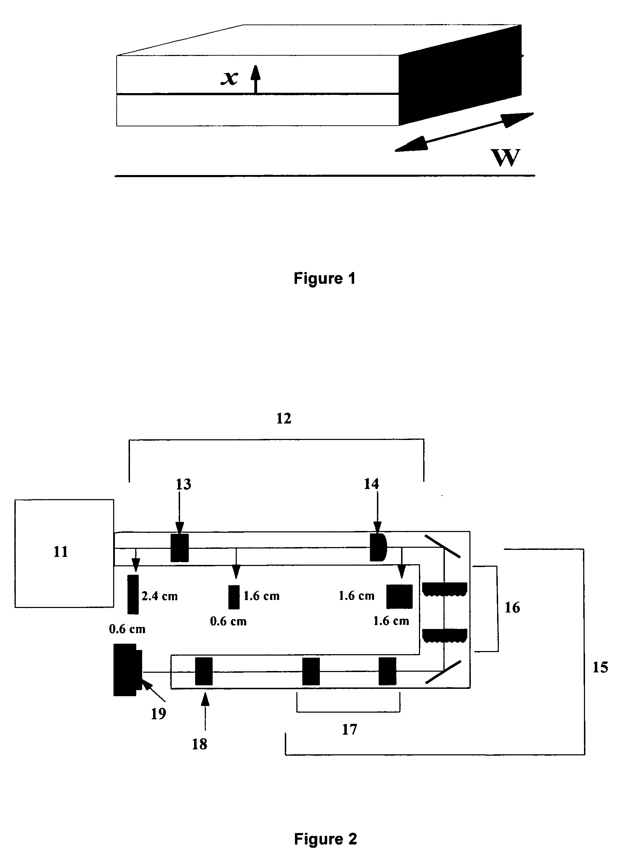

The preferred internal strain gradient is between $-0.8 \cdot 10^{-3}/\mu m$ and $+0.8 \cdot 10^{-3}/\mu m$ or between $-0.8 \cdot 10^{-4}/\mu m$ and $+0.8 \cdot 10^{-4}/\mu m$ or between $-0.8 \cdot 10^{-5}/\mu m$ and $+0.8 \cdot 10^{-5}/\mu m$. The internal strain gradient of a layer is defined by the internal stress gradient of the layer divided by Young's modulus. For a silicon germanium layer, Young's modulus is between 120 GPa and 170 GPa, depending on the Ge content of the layer. The internal stress gradient is defined by M/I where M is the internal moment and I the inertial moment of the layer. The internal moment M is defined as $w\int \sigma x dx$ and the inertial moment I is defined as $w\int x^2 dx$ wherein w is the width of the layer, σ is the stress and x is the distance from the neutral plane on the axis perpendicular to the plane formed by the layer (Figure 1). If the strain gradient is different from zero, microstructures can deform. For example, surface micromachined cantilevers can bend upwards if lower layers in a stack of layers exhibit a more compressive stress than upper layers in this stack of layers or if upper layers exhibit a more tensile stress than underlying layers. Free-standing structures can bend downwards if lower layers have more tensile stress than upper layers or upper layers have more compressive stress than underlying layers. Out of plane bending can be measured by scanning the surface of the cantilever by a laser beam that has a spot smaller than 5 μm and a vertical resolution around 5 nm. Average stress can be determined by measuring the wafer curvature before and after deposition.

Because of the electronic performance of the devices, crystalline layers need to be obtained. In order to obtain for example a (poly)crystalline silicon germanium layer, the deposition temperature should be at least 400°C. At lower temperatures normally no crystalline deposition is possible and amorphous layers are obtained, such that subsequent crystallization by annealing is required. This annealing step may however give rise to large stresses or strain gradients in the layers, making them unsuitable for micromachining.

Embodiments of the present invention deal with the development of structural silicon germanium layers for micromachined devices at temperatures below 400°C, thereby obtaining the required properties for these structural layers, such as average stress, internal strain gradient, electrical and thermal conductivity, surface roughness and internal dissipation. More in particular, embodiments of the present invention deal with the development of high quality structural silicon germanium layers at temperatures below 250 °C and preferably at temperatures as low as 210 °C.

A method is provided comprising a low temperature deposition step such as a Plasma Enhanced Chemical Vapor Deposition (PECVD) step or another plasma assisted deposition step such as a High Density Plasma CVD step or a plasma sputtering step, followed by a laser annealing step such as pulsed laser annealing step, e.g. an excimer laser annealing step, to tailor the structural, mechanical and electrical properties of the structural layer locally. The high hydrogen content in the PECVD films makes the interaction between the laser pulse and the film more challenging than in the case of LPCVD films. In general, PECVD films deposited at such low temperatures are amorphous as grown, and annealing in a conventional furnace at temperatures slightly higher than the deposition temperature leads to void formation due to hydrogen out-gassing. In this work, the laser annealing conditions have been tuned to optimize crystallization depth and layer quality, while at the same time avoiding thermal influence on the underlying layers. Some deposition conditions examined, for example, include the deposition temperature, deposition pressure, the deposition power, and the germanium content of the layers. Annealing conditions examined include for example the laser pulse fluence, the number of pulses and the pulse rate.

*Experimental setup*

Excimer laser pulses have been generated from a Lambda Physic Compex 205 system (11 in Fig.2) having Krypton Fluoride (KrF) as the lasing gas, resulting in a laser wavelength of 248 nm, a bandwidth of 300 pm and a pulse duration of 24 ns. The output pulse has a rectangular transversal cross section with a width of 0.6 cm and a height of 2.4 cm. The beam intensity has a Gaussian distribution in the vertical and horizontal directions. A beam guiding system was used to reshape the pulse wave front into a square of 1.6 cm x 1.6 cm and to homogenize the intensity of the beam in the transverse direction. A schematic diagram of the beam guiding system is displayed in Fig. 2. It consists of a set of telescopic lenses (12) composed of a horizontal cylindrical lens (13) that shortens the pulse long axis and a vertical cylindrical lens (14) to stretch the beam in the horizontal direction. The intensity of the beam is homogenized in the transverse direction using a homogenizer (15) which is composed of four arrays of cylindrical lenses (16) and (17). Two arrays, each of which is composed of ten vertical cylindrical lenses (16), are used to homogenize the beam in the horizontal direction. The two other arrays consist of ten horizontal cylindrical lenses (17) in order to homogenize the beam in the vertical direction. Finally, the target (19) is placed in the focal plane of a projection lens (18) that reduces the spot size down to 0.58 cm x 0.58 cm.

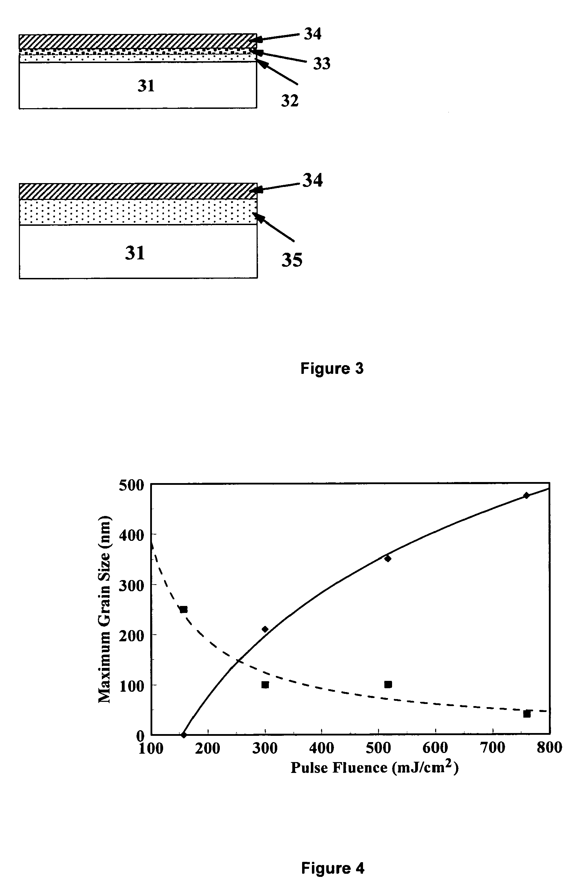

Silicon germanium layers have been deposited by PECVD at temperatures $\leq$ 400°C. The samples under consideration were divided into two sets, as illustrated in Fig.3. The first set (Fig. 3.a) is composed of a 6" Si-substrate (31) having a 250 nm thick layer of thermal oxide (32), on top of which there is 50 nm thick layer of evaporated Al (33), coated with a 0.5 $\mu$m thick silicon germanium layer (34). For the second set of wafers (Fig. 3.b) the 0.5 $\mu$m thick silicon germanium layer (34) was deposited directly on top of a 1.6 $\mu$m thick layer of thermal oxide (35). The silicon germanium deposition was performed in an Oxford Plasma Lab 100 system, which is a plasma enhanced vapor deposition cold wall system. The silicon gas was pure silane, whereas 10% germane in hydrogen was used as the germanium gas source. One percent diborane in hydrogen was used as the boron gas source. The deposition temperature was varied from 210°C to 400°C. For all silicon germanium depositions the deposition pressure was fixed at 2 Torr and the RF power was fixed at 15 W.

*Effect of pulsed laser annealing on grain microstructure and texture*

The grain microstructure of the as-grown and annealed films was investigated by transmission electron microscopy (TEM) and by X-ray diffraction (XRD). From TEM cross sections it was clear that as-grown PECVD $Si_{33}Ge_{67}$ deposited at 370°C is fully amorphous. Exposing this film to a single laser pulse having a fluence of 67 mJ/cm$^2$ does not introduce noticeable change in the grain microstructure. Increasing the pulse fluence to 157 mJ/cm$^2$ results in the generation of fine grains extending over a depth of 200 nm. The grains are characterized by an elongated morphology (as confirmed from the dark field images) and the grain size varies from 40 nm to 200 nm. The defect density, as estimated from the dark field images, is expected to be around 10$^{10}$ defects/cm$^2$. The presence of the fine grains might be due to the self-propagating silicon germanium liquid through the amorphous silicon germanium film. The absence of coarse grains at this energy density indicates that the molten depth is extremely shallow, which means that this fluence brings the silicon germanium in the partial melting regime, where the silicon germanium is in a supercooled state and crystallization might occur from unmolten silicon germanium seeds.

A further increase of the pulse fluence to 300 mJ/cm$^2$ results in a deeper crystallization depth, characterized by two distinct regions: an upper low defect density region (~10$^2$ defects/cm$^2$) having blocky grains with a grain size between 180 nm and 310 nm, and a bottom region having high defect density (~10$^{10}$ defects/cm$^2$) fine grains. Thus,

this fluence lies in the near complete melting regime. Increasing the pulse fluence results in an increase in the maximum temperature and accordingly the melt depth is increased. This results in the generation of blocky, coarse grains close to the surface and fine bottom grains. The depth of the blocky grain region significantly increases by increasing the pulse fluence, whereas the fine grain zone is diminishing. Hence, the fluence is already in the complete melting regime. A detailed inspection of TEM cross sections shows that as the pulse fluence reaches 500 mJ/cm$^2$, tiny pores are generated in the blocky gains, which are much more pronounced at the highest fluence. As the pulse fluence is increased, the film melt depth is increased noticeably. The rapid increase in temperature associated with the pulse absorption causes hydrogen to evolve explosively, resulting in damaging the film, which is pronounced in the pores observed in TEM cross sections. Figure 4 gives a quantitative idea about the effect of the pulse fluence on the maximum grain size of both blocky and fine grains. The blocky grain size, $GS_{bg}$ has a logarithmic dependence on the pulse fluence, E, as is clear from the solid line in Fig. 4, which can be expressed by the following experimental formula:

$$GS_{bg} = 298 \ln(E) - 1502 \text{ (nm)} \tag{1}$$

where E is the pulse fluence in mJ/cm$^2$. On the other hand, the dashed line in Fig. 4 indicates that the size of the fine grains, $GS_{fg}$, varies inversely to the pulse fluence according to the following empirical formula:

$$GSfg = 43967/E \text{ (nm)} \tag{2}$$

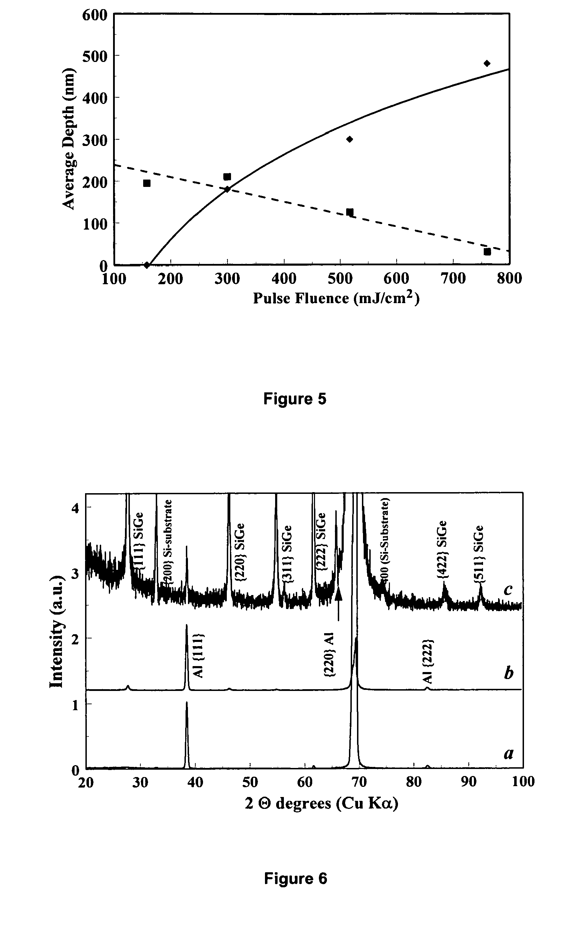

The crystallization depth $GD_{bg}$ of the blocky grains increases logarithmically with the pulse fluence, as is clear from the solid line in Fig. 5. It can be defined by the following formula:

$$GD_{bg} = 293 \ln(E) - 1492 \text{ (nm)} \tag{3}$$

This behavior is very similar to the dependence of the grain size on the pulse fluence (equation (1)), which might indicate that the grains are expanding laterally and transversely at the same rate. On the other hand, the dashed line in Fig. 5 shows that the crystallization depth of the fine grain zone, $GD_{fg}$, is decreasing linearly with the pulse fluence and is expressed as:

$$GDfg = 269 - 0.297 \, E \text{ (nm)} \tag{4}$$

An important aspect is the penetration depth of the laser annealing process. It is reported that Al re-crystallizes at around 200°C, which results in textural changes. Accordingly, monitoring the textural changes in the bottom Al layer (33 in Fig.3) underneath the silicon germanium layer (34) by X-ray diffraction spectroscopy (XRD) can give an idea about the thermal penetration depth of the laser pulse. By inspecting the XRD patterns displayed in Fig. 6.a and 6.b it is noticed that for pulse fluences as high as 420 mJ/cm$^2$ there is no change in the Al texture as compared to the as grown texture. This indicates that the temperature of Al did not exceed the silicon germanium deposition temperature, which is 370°C in this case. On the other hand, increasing the pulse fluence to 760 mJ/cm$^2$ results in a changed Al texture, which is clear from the generation of the {220} peak (Fig. 6.c). This indicates that the temperature of Al already exceeded the deposition temperature of the silicon germanium layer and the annealing process is no longer depth-limited. Thus it is recommended to limit the pulse fluence to 400 mJ/cm$^2$ or lower, to keep the laser treatment limited in depth.

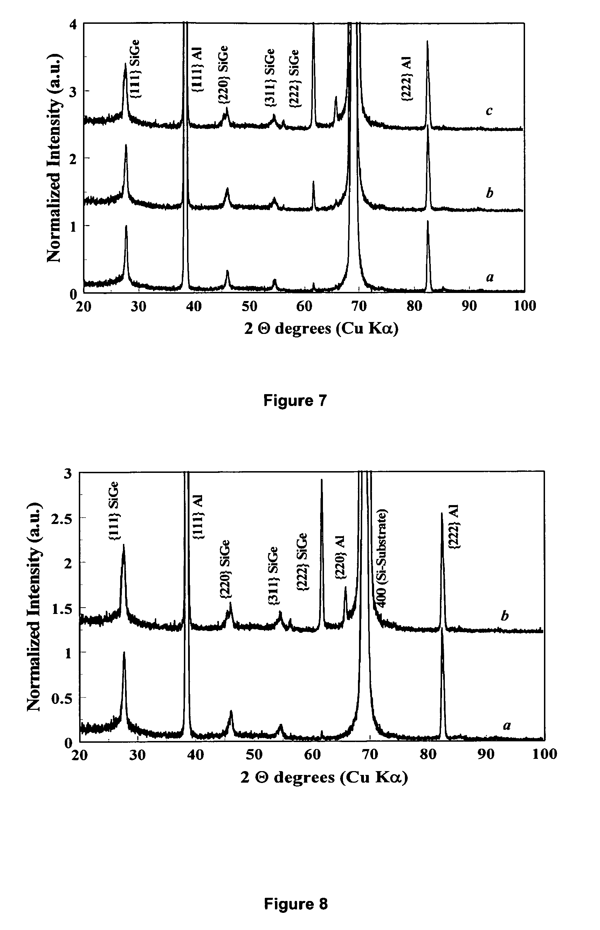

The grain microstructure is not only affected by the pulse fluence, but also the pulse number and rate might have a significant impact. From the XRD patterns in Fig. 7 it is clear that increasing the pulse number to 100 at a rate of 10 Hz results in the generation of a weak {220} Al peak, which is not pronounced if the film is only exposed to a single pulse. Furthermore, some splitting in the {311} silicon germanium peaks can be seen. For the same number of pulses, increasing the pulse rate to 50 Hz, gives rise to a prominent {220} Al peak and results in a more obvious splitting in the silicon germanium {311} peak. The splitting of the silicon germanium peaks might be due to the diffusion of silicon atoms, which is activated by the increased amount of heat dissipated in the film associated with the higher pulse rate. This results in intermixing between the silicon and the germanium atoms, which results in a Ge concentration gradient across the film thickness. Hence, the process can not be considered any more depth-limited due to the observed textural changes in the bottom Al layer. To guarantee that the heat generated by the laser pulse is localized in depth and at the same time, to avoid any damage to the silicon germanium layer, it is recommended to use a large number of pulses with a low pulse fluence applied at maximum rate. The exact values depend on the layer thickness. The XRD pattern displayed in Fig. 8.a shows that for a 0.4 $\mu$m thick $Si_{25}Ge_{75}$ layer, the optimal laser annealing condition would be 500 pulses having a fluence of 160 mJ/cm$^2$ and applied at 50 Hz, as this does not affect the bottom Al layer nor introduces any splitting in the SiGe peaks. The effectiveness of increasing the pulse number and rate is more pronounced at lower pulse fluence. From TEM cross sections it is clear that a single pulse at a fluence of 67 mJ/cm$^2$ does not introduce any change into the film. On the other hand, applying 500 pulses of 67 mJ/cm$^2$ at 50 Hz results in a crystallization depth of 50 nm and a grain size of about 25 nm.

*Micromachined devices*

In general, the measured average stress in as-grown PECVD $Si_xGe_{1-x}$ films deposited at temperatures between 300°C and 400° C is compressive with the upper layers more compressed than the lower ones. This results in an out of plane deflection of surface micromachined structures. For micromachined structures realized by 1.4 $\mu$m thick $Si_{31}Ge_{69}$ films deposited at 400°C it was experimentally shown that exposing these films to 500 laser pulses at 158 mJ/cm$^2$ significantly reduces the strain gradient and the average stress. As-deposited surface micromachined diamond structures were buckling due to the compressive stress in the as grown material. After laser annealing the structures were flat and suspended, which confirms low tensile stress. On the other hand, the top layers of the as grown film were much more compressed than the lower ones, as was clear form the out of plane deflection observed for surface micromachined cantilevers. After laser annealing, the top layers were tensile due to re-crystallization, and this resulted in a more uniform stress distribution across the film thickness and a flat profile of the surface micromachined cantilevers. Also, it was found that exposing 0.77 $\mu$m thick PECVD $Si_{31}Ge_{69}$ films deposited at 300°C to 500 pulses at 70 mJ/cm$^2$ reduces their average stress and sheet resistance, from 93 MPa compressive to 48 MPa compressive and from 450 kOhm/square to 600 mOhm/square respectively. Using the same pulse number and rate while increasing the fluence to 100 mJ/cm$^2$ converts the average stress of a similar film on top of an Al layer from 85 MPa compressive to 90 MPa tensile. This illustrates the possibility of fine-tuning the mechanical properties of silicon germanium layers by optimizing the laser annealing conditions.

*Laser annealing of silicon germanium deposited at 210°C*

In another set of experiments the effect of pulsed laser annealing on silicon germanium layers deposited at 210°C was investigated. Such temperature is compatible with a wide variety of substrates and driving electronics. The correlation between the optimal laser annealing conditions and the deposition parameters was investigated, more specifically the Ge content, layer thickness and deposition pressure, as these parameters have a significant influence in determining the optimal laser annealing conditions for surface micromachining. Tuning the laser parameters to optimize the physical properties of PECVD silicon germanium is challenging, especially for films deposited at low temperatures due to the high hydrogen content and the poor adhesion of these films. In this invention, the deposition conditions of silicon germanium have been adjusted to have a good adhesion to silicon dioxide, to yield a growth rate higher than 20 nm/min at 210°C and to obtain an initial strain gradient that can be tuned by excimer laser annealing. Furthermore, the effect of varying the laser pulse fluence, rate and number on strain gradient, electrical conductivity and surface roughness have been investigated. The range of Ge contents under consideration is selected to broaden the use of silicon germanium to a wide variety of applications, which include, but are not limited to, uncooled thermal imagers, inertial sensors, RF filters, micromirrors, etc.

$Si_{1-x}Ge_x$ films were deposited directly on top of a 1.6 $\mu$m thick layer of thermal oxide by means of PECVD. The deposition temperature was fixed at 210°C whereas the deposition pressure was changed from 0.5 Torr to 2 Torr. For all depositions the RF power was set to 22 W. To improve adhesion between $Si_{1-x}Ge_x$ and $SiO_2$, an undoped amorphous silicon layer was deposited prior to $Si_{1-x}Ge_x$ at 210°C, 30 W and 2 Torr for 3 minutes. The estimated thickness of this bottom Si layer is 180 nm. In spite of the fact that this layer is quite thick, it was found that this is the minimum thickness required for good adhesion. Due to the low deposition temperature (210°C), all as-grown silicon germanium films are amorphous.

Pulsed Excimer laser annealing was used to crystallize the films and to tune the electrical conductivity to the required level. The advantage of this approach is that the thermal treatment is limited in depth, and hence, the top films are exposed to high temperatures, whereas the underlying layers are not thermally affected. As discussed above, the crystallization depth depends on the pulse fluence, rate and number. Also, laser crystallization results in top tensile layers, and consequently an increase in the average tensile stress. Hence, to eliminate the strain gradient after laser annealing, and to have a low average tensile stress, or ideally zero average stress, it is recommended to start with as-grown material having top layers which are more compressive than the bottom ones. Furthermore, the average stress of the as-grown film should be initially compressive as it will be converted to tensile after laser annealing due to contractions against grain boundaries which is typically associated with crystallization. Therefore the effect of deposition conditions on average stress and strain gradient was investigated and the possibility of getting values suitable for post-laser annealing was checked. The deposition parameters that were varied are the Ge content, the layer thickness and the deposition pressure.

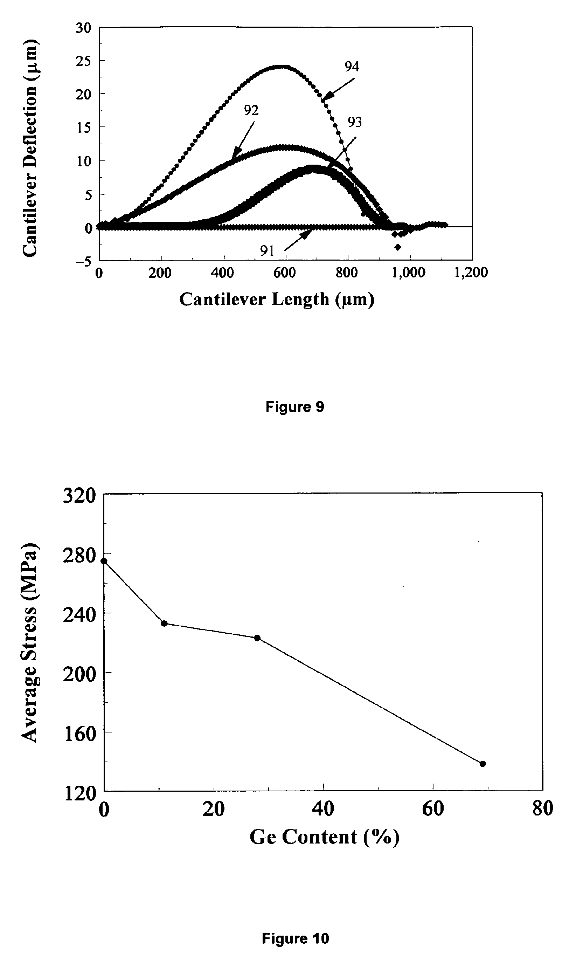

In general, there are two approaches to realize films having a top compressive surface. The first approach relies mainly on the fact that, for the same Ge content, increasing the film thickness is associated with an increase in the compressive stress of the $Si_{1-x}Ge_x$ layer relative to the bottom nucleation layer. The stars (91) and diamonds (92) in Fig. 9 clarify this issue for a $Si_{89}Ge_{11}$ film deposited at 2 Torr. In this case, it is clear that 1 mm long surface micromachined cantilevers realized by a 0.8 $\mu$m thick $Si_{89}Ge_{11}$ film are completely flat (91), which indicates that the bending moments of the top $Si_{1-x}Ge_x$ layer compensates that of the nucleation layer. On the other hand, the diamonds in Fig. 9 (92) show that increasing the film thickness to 1.5 $\mu$m makes the top film more compressive relative to the bottom one and hence results in the out-of-plane deflection presented by the diamonds, which is compatible with laser-post annealing.

The second approach relies mainly on the fact that, for the same layer thickness, varying the Ge content has a significant influence on the out-of-plane deflection. This is mainly due to the fact that the film tends to be more compressive as the Ge content is increased. Fig. 10 clarifies this issue where it shows a noticeable decrease in the average tensile stress as the Ge content is increased. Thus, the minimum thickness at which the desired out-of-plane deflection is achieved, decreases with increasing Ge content. In general, for various Ge contents, it has been found that the minimum thickness suitable for laser post-annealing is greater than 0.5 $\mu$m. For applications that imply using thinner films, the desired out-of-plane deflection can be realized by depositing multi-layers of $Si_{1-x}Ge_x$ having different Ge contents. The squares (93) in Fig. 9 show that for $Si_{1-x}Ge_x$ multi-layers ($Si/Si_{89}Ge_{11}/Si_{79}Ge_{21}/Si_{72}Ge_{28}$), the thickness can be reduced to 0.2 $\mu$m and still an out-of-plane deflection of more than 6 $\mu$m is obtained. The main idea of this approach is based on fixing the deposition time, and making use of the enhancement of the deposition rate associated with increasing the Ge content to increase the layer thickness gradually as one moves away form the substrate. The combined effect of increasing the Ge content and the layer thickness of the sub-layers relative to each other increases the compressive stress across the film thickness and hence results in the desired out-of-plane deflection for any film thickness. The circles (94) in Fig. 9 show that increasing the layer thickness to 0.6 $\mu$m results in an out-of-plane deflection of 25 $\mu$m. The initial out-of-plane deflection is important for determining the optimal laser annealing conditions and accordingly, the electrical conductivity.

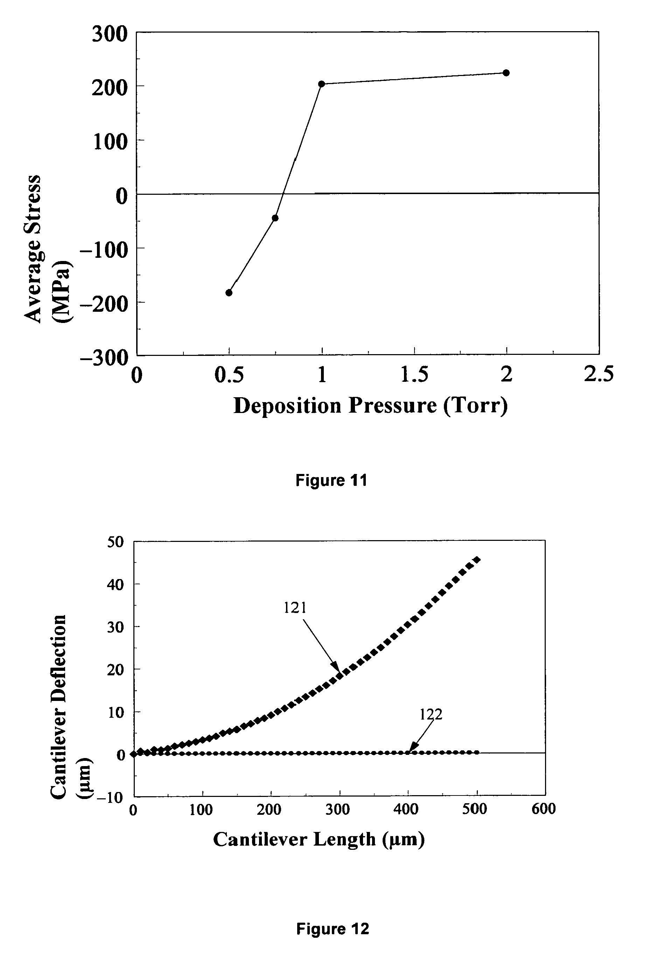

In spite of the fact that strain gradient can be controlled to the desired profile by either tuning the layer thickness or by depositing multi-layers having different Ge contents, an average tensile stress (cfr. Fig. 10) is not suitable for laser annealing as the layers will get even more tensile after the laser treatment due to crystallization. Thus, it is essential to tune the deposition conditions to result in as-grown films with compressive average stress. This can be achieved by reducing the deposition pressure as demonstrated in Fig. 11, which shows that at 0.75 Torr the average stress is slightly compressive. Further reduction of the deposition pressure noticeably increases the average compressive stress. This might be due to the increased hydrogen content in the film, as it has been observed that the film adhesion to the substrate is degraded with decreasing pressure. The optimal deposition pressure is therefore 0.75 Torr. It is also interesting to note that for the same germanium content, reducing the deposition pressure from 2 Torr (121 in Fig. 12) to 1 Torr (122 in Fig. 12) is accompanied by a reduction in strain gradient as is clear from the deflection profile of surface micromachined cantilevers displayed in Fig. 12.

It is worthwhile noting that there is a significant difference between the dependence of strain gradient on deposition conditions for LPCVD $Si_{1-x}Ge_x$ previously reported and that observed for plasma assisted deposition such as PECVD $Si_{1-x}Ge_x$. In the former case it was not possible to get the desired strain gradient directly from an as-grown single layer and it was essential to deposit two layers having different Ge contents and to laser anneal the interface in between the two layers. This approach is quite complicated as it implies removing the wafer from the deposition system, performing laser annealing, cleaning the interface and then return back to the deposition system. In accordance with embodiments of the present invention a single layer can be used. Although the use of PECVD is a preferred method other techniques such HDP CVD and plasma sputtering may be used instead of PECVD in accordance with the present invention.

The optimal laser annealing conditions were identified that result in acceptable electrical and mechanical properties for $Si_{1-x}Ge_x$ films deposited at 210°C, that can be used as a MEMS structural layer. In general, a wide range of high performance micromachining applications imply having a low strain gradient coupled with the lowest possible electrical resistivity (a few mOhm.cm). For as-deposited amorphous PECVD $Si_{1-x}Ge_x$ films, satisfying both criteria at the same time is challenging, especially if the deposition temperature is reduced significantly below 400°C. Reducing the electrical resistivity of as-deposited amorphous film implies having a polycrystalline structure characterized by large grains after laser annealing. However, such crystallization process is typically associated by contractions against grain boundaries which results in a high tensile stress and high strain gradient, which is not suitable for micromachining applications. In addition, treating the films with high laser fluence results in pores inside the grains due to hydrogen evolution. Thus, it might be instructive to start by optimizing the mechanical properties of the film and then investigate the possibility of improving the electrical properties.

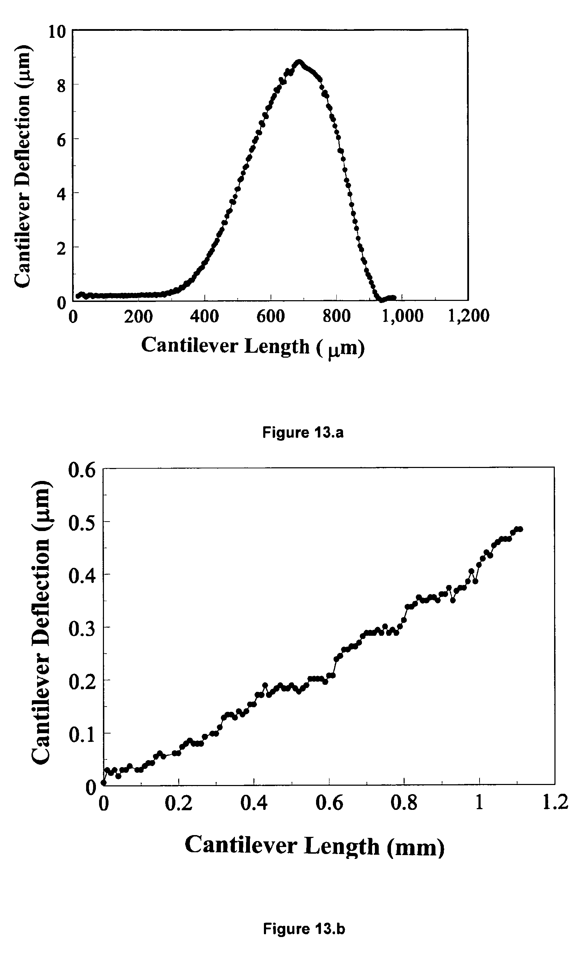

It has been demonstrated in the previous section that the strain gradient of as deposited films can be tuned by either varying the Ge content across the film thickness or by adjusting the film thickness. For each case, the possibility of eliminating strain gradient by pulsed laser annealing was investigated, and the maximum out-of-plane deflection that can be eliminated was identified. It was shown (Fig. 13.a) that for 0.3 $\mu$m thick $Si_{1-x}Ge_x$ multi-layer deposited at 210°C, the initial out-of-plane bending of a 1 mm long surface micromachined cantilever is 8 $\mu$m. Exposing this film to 1000 laser pulses at an energy density of 56 mJ/cm$^2$ and a rate of 50 Hz reduces the out-of-plane deflection to 0.5 $\mu$m as is clear from the quantitative data displayed in Fig. 13.b. This corresponds to a strain gradient of $1 \times 10^{-6}$ $\mu$m$^{-1}$.

In the next step, the maximum out-of-plane deflection that can be eliminated was determined. This maximum out-of-plane deflection defines the maximum layer thickness of the MEMS structural layer. Fig. 14.a shows that for a 1.2 $\mu$m thick $Si_{72}Ge_{28}$ layer, the maximum out-of-plane deflection of surface micromachined cantilevers is 40 $\mu$m (141). Exposing this film to 500 pulses at 10 Hz and 56 mJ/cm$^2$ fluence reduces the out-of-plane deflection down to 5 $\mu$m (142). It is also clear from the figure that increasing the number of pulses (143) has a negligible effect on reducing the maximum out-of-plane deflection, but it changes the cantilever profile. This is mainly due to the fact that the penetration depth is not affected, but increasing the number of pulses at a high rate results in lateral grain growth. Thus, the pulse number and rate can be used to slightly tune the cantilever profile until the desired deflection is achieved. On the other hand, increasing the pulse fluence is not recommended as a 30% increase in the pulse fluence causes a severe increase in strain gradient due to a deeper molten depth and hence a significant change in the grain microstructure. Thus, to eliminate the strain gradient completely, the initial out-of-plane bending should be slightly reduced, which can be done by decreasing the film thickness. Accordingly, it is clear that there is a limitation on the range of film thicknesses for which the laser treatment can be effective in eliminating the strain gradient. For a given Ge content, the layer thickness should be sufficient to have a top compressive surface. On the other hand, the maximum layer thickness corresponds to an out-of-plane deflection of about 30 $\mu$m. For a film with 28% Ge content, this thickness range will be between 0.5 $\mu$m and 1 $\mu$m.

Changing the Ge content has a significant effect on the maximum out-of-plane deflection that can be eliminated by laser annealing. Fig. 14.b clarifies this issue, where it can be noticed that exposing a 1.5 $\mu$m thick $Si_{89}Ge_{11}$ layer to 500 pulses at 10 Hz and 56 mJ/cm$^2$, reduces the out-of-plane deflection from 8 $\mu$m (144) to 5 $\mu$m (145) only. This figure also shows the effect of the pulse rate and number for the same fluence (146), which is again similar to what has been observed for films with 28% Ge (Fig. 14.a). Thus, to eliminate the strain gradient completely, the maximum initial out-of-plane deflection should be tuned to be around 2 $\mu$m, which can be realized by a 1 $\mu$m thick film. On the other hand, the stars (91) in Fig. 9 show that, when the film thickness is reduced to 0.8 $\mu$m, the cantilevers are almost flat. Thus, for lower Ge contents the range of thickness that can be controlled by laser annealing is significantly reduced (between 0.8 $\mu$m and 1 $\mu$m).

The different behavior observed for various Ge contents in response to the same laser treatment can be explained by the fact that as the Ge content is increased, the latent heat for melting and solidification is noticeably reduced and hence, there are significant structural changes associated with higher Ge contents. This is confirmed by sheet resistance measurements of films having different Ge contents and exposed to the same laser dose. By investigating Fig. 15, it can be noticed that for a laser energy density of 56 mJ/cm$^2$, which is suitable for reducing the strain gradient, increasing the Ge content from 28% (151) to 69% (152), results in a reduction of the sheet resistance by two orders of magnitude (in spite of the fact that the number of pulses for higher Ge content is lower). It is also interesting to note that as the laser energy density is increased, the change in sheet resistance is noticeably reduced. This is mainly due to the fact that in this case the laser fluence is high enough to produce significant structural changes which in turn results in high stress. Accordingly, the optimal laser annealing conditions for $Si_{1-x}Ge_x$ deposited at 210°C is a large number of pulses (> 500) at a rate of 50 Hz and an energy density around 55 mJ/cm$^2$ (irrespective of the Ge content).

The optimal laser energy density depends strongly on the material deposition temperature. Materials deposited at 210°C are very sensitive to any thermal treatment. It was found that for 0.65 $\mu$m thick $Si_{86}Ge_{14}$ films deposited at 300°C (161 in Fig. 16), the optimal pulse fluence that eliminates an out-of-plane deflection of 0.5 $\mu$m is 500 pulses at 70 mJ/cm$^2$ (162 in Fig. 16). For PECVD $Si_{1-x}Ge_x$ films deposited at 370°C the pulse fluence can be increased to 160 mJ/cm$^2$ to eliminate the strain gradient. For LPCVD films deposited at 425°C, the pulse fluence can be increased to 300 mJ/cm$^2$. Clearly there is a relation between the deposition temperature and the maximum pulse fluence.

For micromachining applications not only a low strain gradient but also the electrical properties and surface roughness can be critical for the functionality of some MEMS devices. Therefore, the minimum electrical resistivity that can be achieved was determined. It was found that increasing the number of pulses has a minor impact on the strain gradient as it does not increase the penetration depth. On the other hand, the lateral grain growth associated with increasing the number of pulses has a positive impact on reducing the electrical resistivity as demonstrated in Fig. 17. By investigating this figure it is clear that for a 1.8 $\mu$m thick $Si_{72}Ge_{28}$ film (171), the sheet resistance decreases exponentially with increasing the number of pulses. This is mainly due to the lateral grain growth which is clear from AFM images. For 28% Ge content, the minimum resistivity, after 3500 pulses, is 3 $\Omega$.cm (171) which is relatively high, and the corresponding RMS surface roughness is around 50 nm. It was shown that the as-grown $Si_{72}Ge_{28}$ film is very smooth (RMS surface roughness is around 6 nm). This is mainly due to the fact that it is amorphous. After 1500 pulses at 56 $mJ/cm^2$, which are suitable for eliminating the strain gradient, the surface roughness increases to 35 nm. This is thought to be mainly due to crystallization, which is confirmed by the relatively low resistivity displayed in Fig. 17.

Increasing the Ge content to 69% results in a noticeable reduction in the sheet resistance even after a relatively low number of pulses, as demonstrated by the diamonds in Fig. 17 (172). After 500 pulses the resistivity drops to 140 mΩ.cm. For a larger number of pulses, there is a slight dependence on sheet resistance indicating that most of the structural changes occurred at around 500 pulses. In spite of the fact that for a high Ge content (> 60%) the resistivity is noticeably reduced after laser annealing, these layers cannot really be used, as such high Ge content is not fully compatible with standard VLSI processes. Moreover, it might affect device reliability as Ge is more affected by humidity compared to silicon. Also, some applications, such as uncooled surface micromachined IR detectors, might require a low Ge content to reduce thermal conductivity (which is minimized at around 30% Ge). Thus, it is recommended to keep the Ge content below 60%, and accommodate the corresponding high resistivity.

**Claims**

1. A method of manufacturing a silicon germanium layer with a predetermined average stress and a predetermined strain gradient for use as a structural layer in micromachined structures, the method comprising the steps of:

    depositing a single silicon germanium layer on a substrate, said silicon germanium layer having an average stress and a strain gradient; and
    annealing a predetermined part of said silicon germanium layer,

    whereby the process parameters of at least one of said depositing step and said annealing step are selected such that said predetermined average stress and said predetermined strain gradient are obtained in said predetermined part of said silicon germanium layer.

2. The method of claim 1, wherein the depositing of the single silicon germanium layer on the substrate is performed in the presence of a plasma or by a plasma assisted deposition process.

3. The method according to claim 1 or 2, wherein said process parameters of said step of depositing said silicon germanium layer comprise any one or more of:

    the deposition temperature;
    the deposition pressure;
    the deposition power;
    the deposition time or the thickness of said silicon germanium layer;
    and
    the germanium concentration in said silicon germanium layer.

4. The method according to any previous claim, wherein said step of depositing said silicon germanium layer is performed at a temperature below 400 °C, at a temperature below 370 °C, at a temperature below 350 °C, at a temperature below 300 °C, at a temperature below 250 °C, or at a temperature below 230 °C.

5. The method according to any previous claim, wherein said step of depositing said silicon germanium layer is performed at a temperature of 210°C or at a temperature below 210°C.

6. The method according to any previous claim 1, wherein said step of depositing said silicon germanium layer is performed at a pressure between 0,5 Torr and 2 Torr.

7. The method according to any previous claim, wherein the thickness of said silicon germanium layer is between 0 nm and 2000 nm, or between 500 nm and 1500 nm.

8. The method according to any previous claim, wherein the germanium content in said silicon germanium layer is lower than 90%, lower than 70%, lower than 50%, or lower than 30 %.

9. The method according to any previous claim, wherein the germanium content in said silicon germanium layer changes gradually over the layer thickness, between 11 % Ge and 30% Ge or between 0% Ge and 50% Ge.

10. The method according to any of the previous claims, wherein the process parameters of said depositing step are selected such that the deposited silicon germanium layer is an amorphous silicon germanium layer.

11. The method according to any of the previous claims, wherein the process parameters of said depositing step are selected such that the deposited silicon germanium layer has a compressive stress, and whereby the process parameters of said annealing step are selected such that said compressive stress is reduced by said annealing step.

12. The method according to any of the previous claims, wherein the process parameters of said depositing step are selected such that the deposited silicon germanium layer has a compressive stress between 50 MPa and 150 MPa., and whereby the process parameters of said annealing step are selected such that said compressive stress is converted to a low tensile stress (< 100MPa tensile) by said annealing step.

13. The method of any previous claim, wherein said step of depositing said silicon germanium layer is performed by means of a plasma enhanced chemical vapor deposition (PECVD) process.

14. The method according to any of the previous claims, wherein said annealing step is performed by using a pulsed excimer laser.

15. The method according to claim 14, wherein said process parameters of said annealing step include:

> the laser pulse fluence;
> the number of laser pulses; and
> the pulse repetition rate.

16. The method according to claim 15, wherein said laser pulse fluence is between 20 mJ/cm$^2$ and 600 mJ/cm$^2$, or between 60 mJ/cm$^2$ and 600 mJ/cm$^2$, or between 70 mJ/cm$^2$ and 700 mJ/cm$^2$.

17. The method according to claim 15 or 16, wherein said number of laser pulses is between 1 and 1000, or between 1 and 500.

18. The method according to any of claims 15 to 17, wherein said pulse repetition rate is between 1 Hz and 50 Hz.

19. The method according to any of the previous claims, wherein the internal strain gradient of said predetermined part of said silicon germanium layer after said annealing step is between -0.8 10$^{-3}$/$\mu$m and +0.8 10$^{-3}$/$\mu$m or between -0.8 10$^{-4}$/$\mu$m and +0.8 10$^{-4}$/$\mu$m or between -0.8 10$^{-5}$/$\mu$m and +0.8 10$^{-5}$/$\mu$m.

20. The method according to any of the previous claims, wherein the average stress of said predetermined part of said silicon germanium layer after said annealing step is between 50 MPa compressive and 100 MPa tensile.

21. The method according to any of the previous claims, wherein said process parameters of said annealing step are selected such that the thermal penetration depth is limited to said silicon germanium layer.

22. The method according to any of the previous claims, wherein said predetermined part of said silicon germanium layer is at least part of the entire silicon germanium layer, covering at least part of the entire substrate area and including at least part of the entire thickness of said silicon germanium layer.

23. The method according to any of the previous claims, wherein said substrate comprises a semiconductor material, glass or polymeric material.

24. The method according to any of the previous claims, wherein said substrate comprises at least one semiconductor device made by CMOS processing.

25. The method according to any or the previous claims, wherein said substrate includes an insulating layer in addition to a semiconductor substrate portion.

26. The method according any of the previous claims, further comprising:

depositing a sacrificial layer on said substrate before depositing said silicon germanium layer; and
at least partially removing said sacrificial layer after depositing said silicon germanium layer such that a partially freestanding structure is formed that is suitable for MEMS applications.

27. A silicon germanium layer with a predetermined average stress and a predetermined strain gradient for use as a structural layer in a micromachined structures, obtainable by a method according to any of claims 1 to 26.

28. A semiconductor device including the silicon germanium layer of claim 27.

**Figure 1**

**Figure 2**

Figure 3

Figure 4

**Figure 5**

**Figure 6**

Figure 7

Figure 8

Figure 9

Figure 10

Figure 11

Figure 12

Figure 13.a

Figure 13.b

Figure 14.a

Figure 14.b

Figure 15

Figure 16

Figure 17

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030124761 A
- WO 0174708 A

- US 20050037598 A

**Non-patent literature cited in the description**

- **S. SEDKY.** Pulsed-laser Annealing, a Low-Thermal Budget Technique for Eliminating Stress Gradient in Poly-SiGe MEMS structures. *Journal of Microelectromechanical systems,* August 2004, vol. 13 (4